# EUROPEAN PATENT SPECIFICATION

(11) **EP 3 738 140 B1**
(45) Date of publication and mention of the grant of the patent: **06.07.2022**
(21) Application number: 19738304.5
(22) Date of filing: 04.01.2019
(51) Int. Cl.: H01L 21/321, H01L 21/304, H01L 21/3105, C09G 1/02, C09K 3/14

(54) **TUNGSTEN BULK POLISHING METHOD WITH IMPROVED TOPOGRAPHY**
VERFAHREN ZUM POLIEREN VON GROSSEN WOLFRAM-MENGEN MIT VERBESSERTER TOPOGRAPHIE
PROCÉDÉ DE POLISSAGE EN VRAC DE TUNGSTÈNE AYANT UNE TOPOGRAPHIE AMÉLIORÉE

(30) Priority: 09.01.2018 US 201815866008
(43) Date of publication of application: 18.11.2020
(73) Proprietor: CMC Materials, Inc., Aurora, IL 60504 (US)
(72) Inventor: WARD, William J., Aurora, Illinois 60504 (US); CARNES, Matthew E., Aurora, Illinois 60504 (US); CUI, Ji, Aurora, Illinois 60504 (US); LONG, Kim, Aurora, Illinois 60504 (US)
(74) Representative: Barker Brettell LLP
(86) International application number: PCT/US2019/012268
(87) International publication number: WO 2019/139828

(56) References cited:
- WO-A1-2007/056002
- KR-A- 20170 039 970
- US-A1- 2006 189 152
- US-A1- 2009 314 744
- US-A1- 2015 184 028
- US-A1- 2016 251 547

## Description

### BACKGROUND OF THE INVENTION

In the fabrication of integrated circuits and other electronic devices, multiple layers of conducting, semiconducting, and dielectric materials are deposited onto or removed from a substrate surface. As layers of materials are sequentially deposited onto and removed from the substrate, the uppermost surface of the substrate may become non-planar and require planarization. Planarizing a surface, or "polishing" a surface, is a process where material is removed from the surface of the substrate to form a generally even, planar surface. Planarization is useful in removing undesired surface topography and surface defects, such as rough surfaces, agglomerated materials, crystal lattice damage, scratches, and contaminated layers or materials. Planarization also is useful in forming features on a substrate by removing excess deposited material used to fill the features and to provide an even surface for subsequent levels of metallization and processing.

Compositions and methods for planarizing or polishing the surface of a substrate are well known in the art. Chemical-mechanical planarization, or chemical-mechanical polishing (CMP), is a common technique used to planarize substrates. CMP utilizes a chemical composition, known as a CMP composition or more simply as a polishing composition (also referred to as a polishing slurry), for selective removal of material from the substrate. Polishing compositions typically are applied to a substrate by contacting the surface of the substrate with a polishing pad (e.g., polishing cloth or polishing disk) saturated with the polishing composition. The polishing of the substrate typically is further aided by the chemical activity of the polishing composition and/or the mechanical activity of an abrasive suspended in the polishing composition or incorporated into the polishing pad (e.g., fixed abrasive polishing pad).

Substrates that have tungsten features disposed between dielectric features include semiconductor substrates that include tungsten "plug" and "interconnect" structures provided between features of dielectric material. The dielectric material (e.g., a silicon oxide) conforms to the underlying topography of the substrate and as such, the surface of the dielectric material typically is characterized by an uneven combination of raised areas of the dielectric material separated by trenches in the dielectric material. The region of the substrate surface that includes the raised dielectric material and trenches is referred to as a pattern field of the substrate, e.g., as "pattern material," "pattern oxide," or "pattern dielectric."

To produce tungsten "plug" and "interconnect" structures, tungsten is applied over a surface that contains a patterned structure made at least in part from dielectric material. Due to variation in the depth of the trenches, it is typically necessary to deposit an excess of tungsten on top of the substrate to ensure complete filling of all trenches. The excess tungsten is then removed by CMP processing to expose the underlying dielectric layer and to produce a planar surface of the tungsten disposed between the spaces of the dielectric material. Relatively large portions of tungsten are removed during "bulk" polishing, which is desirably characterized by a high tungsten removal rate. However, bulk tungsten polishing must also exhibit suitable topography performance.

Known CMP slurries suffer from a number of drawbacks, e.g., slurries with tungsten removal rate capability can suffer from excessive edge-over erosion (EOE) (sometimes referred to as fanging) which can cause yield loss. As suggested by the name, EOE or fanging refers to the local erosion near the edge of a patterned area. Alternatively, many slurries which can achieve desired topography performance suffer from low film removal rates which increases process times, decreasing device throughput. Moreover, topography performance and defectivity have been identified as gaps in existing silica-based tungsten buffing slurries. Anionic systems can improve defectivity while providing improved colloidal stability for improved shelf-life. However, the use of anionic silicas currently is limited due to a number of factors, for example, aluminum-doped silicas have limited operating formulation space due to pH limitations, attributable to Al-leaching. Also, known slurries formulated with anionic particles like MPS (mercapto-propylsilane sulfonated colloidal silica) are limited due to low film removal rates and poor pattern performance (e.g., high erosion or EOE).

Although EOE phenomena are known in various CMP applications, including silicon, copper, and tungsten CMP, the phenomena are not well understood. U.S. Patent 6,114,248 discloses using reduced levels of colloidal and fumed silicas and increased alkaline chemistry in order to improve EOE in polysilicon polishing. Further, it has been proposed that EOE phenomena in copper CMP can be addressed by modifying electrochemical properties of copper (see, e.g., G. Banerjee and R. L. Rhoades (ECS Transactions, 2008, vol. 13, pp. 1-19)). However, chemical-based solutions to fanging in tungsten polishing applications are not likely to be suitable since tungsten has inherently different electrochemical properties from copper and from silicon. Others have proposed EOE in tungsten CMP can be addressed by modifying mechanical factors (e.g., using small particle colloidal silicas) or processing conditions (e.g., two-step high down force followed by low down-force setting during polishing or reconfiguration of the polishing assembly) (see, e.g., R. Vacassy and Z. Chen, "Edge Over Erosion in Tungsten CMP", 2006, https://www.researchgate.net/publication/290577656; S.H. Shin et al., "Relative Motion and Asymetry Effect Analyses in Tungsten CMP Process," http://www.planarization-cmp.org/contents/ICPT/PacRim2005/S5-2.pdf).

However, modifying processing parameters typically is undesirable due to the complex operations involved, and possible decreases in throughput due to increased polishing times. Modifying processing parameters also can result in lack of uniform polishing characteristics which can negatively impact device yield. In addition, Applicants have found that tungsten polishing slurries formulated with small colloidal silica results in a high propensity of EOE phenomena in tungsten polishing applications.

Thus, there remains a need for compositions and methods for chemical-mechanical polishing of substrates that will provide useful bulk polishing removal rates (e.g., tungsten bulk polishing) while also providing improved planarization efficiency. The invention provides such polishing compositions and methods. These and other advantages of the invention, as well as additional inventive features, will be apparent from the description of the invention provided herein.

### BRIEF SUMMARY OF THE INVENTION

The present invention provides a method of chemically-mechanically polishing a substrate comprising (i) providing a substrate, wherein the substrate comprises a tungsten layer on a surface of the substrate and a silicon oxide layer on a surface of the substrate; (ii) providing a polishing pad; (iii) providing a chemical-mechanical polishing composition comprising (a) surface-modified colloidal silica particles having a negatively-charged group on the surface of the particles, wherein the surface-modified colloidal silica particles have a negative charge, a particle size of about 90 nm to about 350 nm, and a zeta potential of about -20 mV to about -70 mV at a pH of about 2, (b) an iron compound, (c) a stabilizing agent, and (d) an aqueous carrier; (iv) contacting the substrate with the polishing pad and the chemical mechanical polishing composition; and (v) moving the polishing pad and the chemical-mechanical polishing composition relative to the substrate to abrade at least a portion of the tungsten layer on a surface of the substrate and at least a portion of the silicon oxide layer on a surface of the substrate to polish the substrate.

### DETAILED DESCRIPTION OF THE INVENTION

The invention provides a method of chemically mechanically polishing a substrate comprising (i) providing a substrate, wherein the substrate comprises a tungsten layer on a surface of the substrate and a silicon oxide layer on a surface of the substrate; (ii) providing a polishing pad; (iii) providing a chemical-mechanical polishing composition comprising, consisting essentially of, or consisting of (a) surface-modified colloidal silica particles comprising a negatively-charged group on the surface of the particles, wherein the surface-modified colloidal silica particles have a negative charge, a particle size of about 90 nm to about 350 nm, and a zeta potential of about -20 mV to about -70 mV at a pH of about 2, (b) an iron compound, (c) a stabilizing agent, and (d) an aqueous carrier; (iv) contacting the substrate with the polishing pad and the chemical mechanical polishing composition; and (v) moving the polishing pad and the chemical-mechanical polishing composition relative to the substrate to abrade at least a portion of the tungsten layer and at least a portion of the silicon oxide layer to polish the substrate.

Without wishing to be bound to any particular theory, Applicants have discovered that polishing compositions comprising the surface-modified particles described herein having a negative charge, a particle size of about 90 nm to about 350 nm, and a zeta potential of about -20 mV to about -70 mV at a pH of about 2, exhibit improved tungsten removal rate and silicon oxide removal rate capability and exhibit improved topography performance, including lower erosion and fanging.

The polishing composition comprises an abrasive that comprises, consists essentially of, or consists of surface-modified (e.g., surface-functionalized) colloidal silica particles, wherein the colloidal silica particles have been surface-modified such that the modified colloidal silica particles have a negatively charged group on the surface of the particle. Accordingly, the surface-modified colloidal silica particles have a negative charge. The negative charge is provided by modification of the silica particles with negatively charged groups covalently attached to the silica surface.

As used herein, the term "negative charge" refers to a negative charge on the surface-modified colloidal silica particles that is not readily reversible (i.e., irreversible or permanent), for example, via flushing, dilution, or filtration. A negative charge may be the result, for example, of covalently bonding an anionic species (e.g., a negatively-charged group) with the colloidal silica. In contrast, a reversible negative charge (a non-permanent negative charge) may be the result, for example, of an electrostatic interaction between an anionic species and the colloidal silica, such as anionic surfactant or anionic polymer which can, for example, electrostatically bind to the surface of a silica particle.

The negatively-charged group can be any suitable group that can affect a negative charge on the surface of the colloidal silica particles. For example, the negatively-charged group can be an organic acid (e.g., carboxylic acid, sulfonic acid, and/or phosphonic acid). In a preferred embodiment, the negatively-charged group comprises a sulfonate group, a carboxylate group, a phosphonate group, and combinations thereof.

In a preferred embodiment, the sulfonate group is a silane containing one or more sulfonate groups or sulfate groups. The sulfonate group also can be a sulfonate or sulfate precursor, which can subsequently be transformed into sulfonate or sulfate, for example, by oxidation. Suitable sulfonate groups include, for example, 3-(trihydroxysilyl)-1-propanesulfonic acid, triethoxysilylpropyl(polyethyleneoxy)propylsulfonic acid salts thereof such as potassium salts, 3-mercaptopropyltrimethoxysilane, (mercaptomethyl)methyldiethoxysilane, and 3-mercaptopropylmethyldimethoxysilane.

Suitable carboxylate groups or carboxylate precursors include, for example, (3-triethoxysilyl)propylsuccinic anhydride, carboxyethylsilane triol or salts thereof, and N-(trimethoxysilylpropyl)ethylenediaminetriacetic acid or salts thereof.

Suitable phosphonate groups include, for example, 3-(trihydroxysilyl)propyl methylphosphonic acids and salts thereof.

The negatively charged group also may be a silane coupling agent. Silane coupling agents can be used to modify the silica surface to provide surface-modified colloidal silica particles according to the invention. Examples of silane coupling agents which include negatively charged groups or precursors for negatively charged groups are described by Gelest, Inc. (Silane Coupling Agents, Copyright 2014, Gelest, Inc., Morrisville, PA).

The surface-modified colloidal silica particles can be prepared using any suitable method. Typically, the colloidal silica particles, prior to surface-modification with the negatively-charged group(s) (i.e., unmodified colloidal silica particles), are free or substantially free of negatively charged groups. The unmodified colloidal silica particles can be any suitable colloidal silica particles and are typically "wet-process" colloidal silica particles. As used herein, "wet-process" silica refers to a silica prepared by a precipitation, condensation-polymerization, or similar process (as opposed to, for example, fumed or pyrogenic silica). In a preferred embodiment, the colloidal silica particles are prepared by condensation-polymerization of Si(OH)₄. The precursor Si(OH)₄ can be obtained, for example, by hydrolysis of high purity alkoxysilanes such as tetramethylorthosilicate (TMOS). Such colloidal silica particles can be obtained as various commercially available products, such as the Fuso Chemical Co.'s "PL" colloidal silica products, such as PL-5 and PL-7. In another preferred embodiment, the silica particles are prepared from sodium silicates. Sodium silicates useful to the invention can for example be obtained from Nalco. Examples of commercial colloidal silicas derived from sodium silicate include Nalco 1050, 2327, and 2329 products, as well as other similar products available from DuPont, Bayer, Applied Research, Nissan Chemical, and Clariant.

The colloidal silica particles can be surface-modified using any suitable method. In an embodiment, the surface treatment for providing a negatively-charged group to the surface of the colloidal silica particle is through silane surface reaction with the colloidal silica. For example, in the case of covalently attaching a sulfonic acid (e.g., a sulfonate group), which is an organic acid, to the colloidal silica, attachment can be carried out according to the method of Cano-Serrano et al., "Sulfonic acid-functionalized silica through quantitative oxidation of thiol groups", Chem. Commun., 2003(2): 246-247 (2003). Specifically, the colloidal silica with sulfonic acids covalently attached to its surface is obtained by coupling silane coupling agents having a thiol group such as (3-mercaptopropyl)trimethoxysilane with the colloidal silica and then oxidizing the thiol group using a hydrogen peroxide water. Alternatively, for example, in the case of covalently attaching a carboxylic acid (i.e., a carboxylate group) to the colloidal silica, attachment can be carried out according to the method of Yamaguchi et al., "Novel silane coupling agents containing a photolabile 2-nitrobenzyl ester for introduction of a carboxy group", Chemistry Letters, 3: 228-229 (2000). Specifically, the colloidal silica with a carboxylic acid covalently attached to its surface is obtained by coupling silane coupling agents containing photosensitive 2-nitrovinzyl ester with the colloidal silica and then irradiating it with light.

The surface-modified colloidal silica particles have a particle size of about 90 nm to about 350 nm. As used herein, particle size refers to the diameter of the smallest sphere that encompasses the particle. The particle size of the colloidal silica particles can be measured using any suitable technique, for example, light scattering techniques. Suitable particle size measurement instruments are available from, for example, Malvern Instruments (Malvern, UK). The particle size can be measured using any suitable technique known to those skilled in the art, for example, laser diffraction techniques, differential centrifugal sedimentation (DCS) using a disc centrifuge such as from CPS Instruments (Prairieville, La.) (e.g., CPS Disc Centrifuge Model DC24000UHR).

Thus, the surface-modified colloidal silica particles can have a particle size of about 90 nm or more, for example, about 95 nm or more, about 100 nm or more, about 105 nm or more, about 110 nm or more, about 115 nm or more, about 120 nm or more, about 125 nm or more, about 130 nm or more, about 135 nm or more, about 140 nm or more, about 145 nm or more, about 150 nm or more, about 155 nm or more, about 160 nm or more, about 165 nm or more, about 170 nm or more, about 175 nm or more, about 180 nm or more, about 185 nm or more, about 190 nm or more, about 195 or more, or about 200 nm or more. Alternatively, or in addition, the colloidal silica particles can have a particle size of about 350 nm or less, for example, about 345 nm or less, about 340 nm or less, about 335 nm or less, about 330 nm or less, about 325 nm or less, about 320 nm or less, about 315 nm or less, about 310 nm or less, about 305 nm or less, about 300 nm or less, about 295 nm or less, about 290 nm or less, about 285 nm or less, about 280 nm or less, about 275 nm or less, about 270 nm or less, about 265 nm or less, about 260 nm or less, about 255 nm or less, about 250 nm or less, about 245 nm or less, about 240 nm or less, about 235 nm or less, about 230 nm or less, about 225 nm or less, about 220 nm or less, about 215 nm or less, about 210 nm or less, or about 205 nm or less. Thus, the colloidal silica particles can have a particle size bounded by any two of the aforementioned endpoints. For example, the colloidal silica particles can have a particle size of about 90 nm to about 350 nm, about 95 nm to about 345 nm, about 90 nm to about 340 nm, or about 85 nm to about 335 nm.

In an embodiment, the colloidal silica particles have a particle size of about 90 nm to about 180 nm.

In another embodiment, the colloidal silica particles have a particle size of about 120 nm to about 180 nm.

The surface-modified colloidal silica particles have a negative zeta potential, more particularly, a zeta potential of about -20 mV to about -70 mV (e.g., about -25 mV, about -30 mV, about -35 mV, about -40 mV, about -45 mV, about -50 mV, about -55 mV, about -60 mV, or about -65 mV) at a pH of about 2. The zeta potential of a particle refers to the difference between the electrical charge of the ions surrounding the particle and the electrical charge of the bulk solution (e.g., the aqueous carrier and any other components dissolved therein). The zeta potential is typically dependent on the pH of the aqueous medium (e.g., aqueous carrier). For a given polishing composition, the isoelectric point of the particles is defined as the pH at which the zeta potential is zero. As the pH is increased or decreased away from the isoelectric point, the surface charge (and hence the zeta potential) is correspondingly decreased or increased (to negative or positive zeta potential values). Moreover, in the context of the present invention, the zeta potential is an indicator of the degree of surface-modification of the colloidal silica particles since a more negative zeta potential over a pH range of about 1.5 to about 3 generally corresponds to a higher degree of surface-modification.

Accordingly, any two of the aforementioned zeta potential values can be used to define a range. For example, surface-modified colloidal silica particles can have a zeta potential of about -25 mV to about -65 mV, about -30 mV to about -60 mV, about -35 mV to about -55 mV, or about -40 mV to about -50 mV over a pH range of about 1.5 to about 3. By way of further example, the surface-modified colloidal silica particles can have a zeta potential of about -20 mV, about -21 mV, about -22 mV, about -23 mV, about -24 mV, about -25 mV, about -26 mV, about -27 mV, about -28 mV, about -29 mV, about -30 mV, about - 31 mV, about -32 mV, about -33 mV, about -34 mV, about -35 mV, about -36 mV, about -37 mV, about -38 mV, about -39 mV, about -40 mV, about -41 mV, about -42 mV, about -43 mV, about -44 mV, about -45 mV, about -46 mV, about -47 mV, about -48 mV, about -49 mV, about -50 mV, about -51 mV, about -52 mV, about -53 mV, about -54 mV, about -55 mV, about -56 mV, about -57 mV, about -58 mV, about -59 mV, about -60 mV, about -61 mV, about -62 mV, about -63 mV, about -64 mV, about -65 mV, about -66 mV, about -67 mV, about -68 mV, about -69 mV, or about -70 mV at a pH of about 2. Thus, the surface-modified colloidal silica particles have a suitable zeta potential over a suitable pH range. Typically, the pH of the polishing composition is about 1.5 to about 3 (e.g., a pH of about 1.6, about 1.7, about 1.8, about 1.9, about 2, about 2.1, about 2.2, about 2.3, about 2.4, about 2.5, about 2.6, about 2.7, about 2.8, or about 2.9). For example, the pH of the polishing composition can be from about 1.6 to about 2.9, about 1.7 to about 2.8, about 1.8 to about 2.7, about 1.9 to about 2.6, about 2 to about 2.5, about 2.1 to about 2.4, or about 2.2 to about 2.3.

In an embodiment, the pH of the polishing composition is about 1.8 to about 3.

In some embodiments, the surface-modified colloidal silica particles have a zeta potential of about -35 mV to about -45 mV over a pH range of about 1.5 to about 3.

In some embodiments, the surface-modified colloidal silica particles have a zeta potential of about -40 mV to about -45 mV over a pH range of about 2 to about 3.

The zeta potential of the polishing composition can be measured by any suitable means, for example, using commercially available instrumentation such as the DT-1202, an electro-acoustic spectrometer available from Dispersion Technology, Inc. (Bedford Hills, NY). In order to measure the zeta-potential on the DT-1202, it is preferred that the solution be measured at the solids concentration corresponding to the abrasive concentration used in chemical mechanical polishing, for example 2% solids.

The chemical-mechanical polishing composition can comprise any suitable amount of surface-modified colloidal silica particles. If the composition comprises too little surface-modified colloidal silica particles, the composition may not exhibit sufficient removal rate. In contrast, if the polishing composition comprises too many surface-modified colloidal silica particles, the composition may exhibit undesirable polishing performance, may not be cost effective, and/or may lack stability.

The surface-modified colloidal silica particles are suspended in the aqueous carrier of the polishing composition such that surface-modified colloidal silica particles desirably are colloidally stable. As used herein, the term "colloidally stable" refers to the suspension of abrasive particles in the aqueous carrier (e.g., water) and refers to the maintenance of that suspension over time. In the context of the present invention, abrasive particles (i.e., surface-modified colloidal silica particles) are considered colloidally stable if, when the abrasive particles are placed into a 100 mL graduated cylinder and allowed to stand unagitated for a time of 2 hours, the difference between the concentration of particles in the bottom 50 mL of the graduated cylinder ([B] in terms of g/mL) and the concentration of particles in the top 50 mL of the graduated cylinder ([T] in terms of g/mL) divided by the initial concentration of particles in the abrasive composition ([C] in terms of g/mL) is less than or equal to 0.5 (i.e., {[B]-[T]}/[C]≦0.5). The value of [B]-[T]/[C] desirably is less than or equal to 0.3, and preferably is less than or equal to 0.1.

Accordingly, the surface-modified colloidal silica particles typically are present in the polishing composition at a concentration of about 6 wt.% or less, for example, about 5.5 wt.% or less, about 5 wt.% or less, about 4.5 wt.% or less, about 4 wt.% or less, about 3.5 wt.% or less, about 3 wt.% or less, or about 2.5 wt.% or less. Alternatively, or in addition, the surface-modified colloidal silica particles can be present in the polishing composition at a concentration of about 0.1 wt.% or more, for example, about 0.2 wt.% or more, about 0.3 wt.% or more, about 0.4 wt.% or more, about 0.5 wt.% or more, about 1 wt.% or more, about 1.5 wt.% or more, or about 2 wt.% or more. Thus, the surface-modified colloidal silica particles can be present in the polishing composition in a concentration bounded by any two of the aforementioned endpoints. For example, the surface-modified colloidal silica particles can be present in the polishing composition at a concentration of about 0.1 wt.% to about 6 wt.%, e.g., about 0.2 wt.% to about 5.5 wt.%, about 0.3 wt.% to about 5 wt.%, about 0.4 wt.% to about 4.5 wt.%, e.g., about 0.5 wt.% to about 4 wt.%, about 1 wt.% to about 3.5 wt.%, about 1.5 wt. % to about 3 wt.%, or about 2 wt.% to about 2.5 wt.%.

In a preferred embodiment, the surface-modified colloidal silica particles are present in the polishing composition at a concentration of about 0.1 wt.% to about 4.5 wt.%.

The polishing composition of the invention comprises an iron compound. Examples of iron-containing salts are described in U.S. Patents. 5,958,288 and 5,980,775. Suitable iron compounds (e.g., iron containing salts) include, for example, salts of ferric (iron III) or ferrous (iron II) compounds such as iron nitrate, iron sulfate, an iron halide (including fluoride, chloride, bromide, iodide, as well as perchlorates, perbromates, and periodates), or an organic iron compound such as an iron acetate, acetylacetonate, citrate, gluconate, malonate, oxalate, phthalate, or succinates.

In a preferred embodiment, the iron compound is ferric nitrate or a hydrate thereof (e.g., ferric nitrate nonahydrate).

The polishing composition can contain any suitable amount of iron compound. As understood, the active species is iron cation and thus, the amounts described herein refer to amounts of an iron compound which provide the equivalent amount of iron ions in solution. If the polishing composition comprises too little iron compound, the composition may not exhibit sufficient removal rate. In contrast, if the polishing composition comprises too much iron compound, the composition may exhibit undesirable polishing performance, may not be cost effective, and/or may lack stability. Accordingly, the iron compound typically is present in the polishing composition at a concentration of about 1 wt.% or less, e.g., about 0.9 wt.% or less, about 0.8 wt.% or less, about 0.7 wt.% or less, about 0.6 wt.% or less, about 0.5 wt.% or less, about 0.4 wt.% or less, about 0.3 wt.% or less, about 0.2 wt.% or less, about 0.1 wt.% or less, or about 0.05 wt.% or less. Alternatively, or in addition, the iron compound can be present in the polishing composition at a concentration of about 0.001 wt.% or more, for example, about 0.005 wt.% or more, or about 0.01 wt.% or more. Thus, the iron compound can be present in the polishing composition in a concentration bounded by any two of the aforementioned endpoints, for example, at a concentration of about 0.001 wt.% to about 1 wt.%, about 0.005 wt.% to about 0.9 wt.%, about 0.01 wt. % to about 0.8 wt.%, about 0.05 wt.% to about 0.7 wt.%, about 0.1 wt.% to about 0.6 wt.%, about 0.2 wt.% to about 0.5 wt.%, or about 0.3 wt.% to about 0.4 wt.%

In a preferred embodiment, the iron compound is present in the polishing composition at a concentration of about 0.005 wt.% to about 0.1 wt.%.

The polishing composition of the invention comprises a stabilizing agent. Without wishing to be bound to any particular theory, the stabilizing agent helps to control the amount of free metal cation in the composition, thereby attenuating the rate of the catalyst to optimize polishing performance, as described in U.S. Patents. 5,980,775 and 6,068,787.

In another embodiment of the invention, the iron compound can be immobilized on the surface of the abrasive. For example, the iron compound may be comprised of an iron salt with a stabilizing agent that is attached to the surface of the abrasive.

In an embodiment, the stabilizing agent comprises phosphoric acid, o-phosphorylethanolamine, phosphonic acid, alendronic acid, acetic acid, phthalic acid, citric acid, adipic acid, oxalic acid, malonic acid, aspartic acid, succinic acid, glutaric acid, pimelic acid, suberic acid, azelaic acid, sebacic acid, oxalic acid, maleic acid, glutaconic acid, muconic acid, ethylenediaminetetraacetic acid, propylenediaminetetraacetic acid, or combinations thereof.

In a preferred embodiment, the stabilizing agent comprises malonic acid.

The polishing composition can comprise any suitable amount of stabilizing agent. If the composition comprises too little stabilizing agent, the composition may not exhibit sufficient stability. In contrast, if the polishing composition comprises too much stabilizing agent, the composition may exhibit undesirable polishing performance, may not be cost effective, and/or may become unstable. Accordingly, the stabilizing agent typically is present in the polishing composition at a concentration of about 1 wt.% or less, for example, about 0.5 wt.% or less, about 0.1 wt.% or less, about 0.05 wt.% or less, or about 0.01 wt.% or less. Alternatively, or in addition, the stabilizing agent can be present in the polishing composition at a concentration of about 0.0001 wt.% or more, for example, about 0.0005 wt.% or more, about 0.001 wt.% or more, or about 0.005 wt.% or more. Thus, the stabilizing agent can be present in the polishing composition in a concentration bounded by any two of the aforementioned endpoints. For example, the stabilizing agent can be present in the polishing composition at a concentration of about 0.0001 wt.% to about 1 wt.%, e.g., about 0.0005 wt.% to about 0.5 wt.%, about 0.001 wt.% to about 0.1 wt.%, or about 0.005 wt.% to about 0.05 wt.%.

In a preferred embodiment, the polishing composition comprises a stabilizing agent at a concentration of about 0.0001 wt.% to about 0.1 wt.%.

The polishing composition comprises an aqueous carrier. The aqueous carrier comprises water (e.g., deionized water) and may contain one or more water-miscible organic solvents. Examples of organic solvents that can be used include alcohols such as propenyl alcohol, isopropyl alcohol, ethanol, 1-propanol, methanol, 1-hexanol, and the like; aldehydes such as acetylaldehyde and the like; ketones such as acetone, diacetone alcohol, methyl ethyl ketone, and the like; esters such as ethyl formate, propyl formate, ethyl acetate, methyl acetate, methyl lactate, butyl lactate, ethyl lactate, and the like; ethers including sulfoxides such as dimethyl sulfoxide (DMSO), tetrahydrofuran, dioxane, diglyme, and the like; amides such as N, N-dimethylformamide, dimethylimidazolidinone, N-methylpyrrolidone, and the like; polyhydric alcohols and derivatives of the same such as ethylene glycol, glycerol, diethylene glycol, diethylene glycol monomethyl ether, and the like; and nitrogen-containing organic compounds such as acetonitrile, amylamine, isopropylamine, imidazole, dimethylamine, and the like. Preferably, the aqueous carrier is water alone, i.e., without the presence of an organic solvent.

The inventive polishing composition desirably is stable during preparation, extended storage, transport, and use. A stable slurry is one that does not unduly separate or settle during storage (e.g., by settling of suspended abrasive particles), does not exhibit undue particle size growth during storage, and does not exhibit undue particle size growth during use, which would increase the level of defects (especially scratches) present at a surface of a processed substrate.

The polishing composition optionally further comprises one or more other additional components (i.e., additives). For example, depending on the desired polishing application, the inventive polishing composition can comprise one or more additives to improve or enhance the polishing performance. The additives desirably are compatible with other components of the polishing composition. Illustrative additional components include conditioners, scale inhibitors, dispersants, oxidizing agents, pH modifying compounds (e.g., acids or bases), and pH buffering compounds. The polishing composition can comprise a surfactant and/or rheological control agent, including viscosity enhancing agents and coagulants (e.g., polymeric rheological control agents, such as, for example, urethane polymers), a dispersant, a biocide (e.g., KATHON^{™} LX), and the like. Suitable surfactants include, for example, cationic surfactants, anionic surfactants, anionic polyelectrolytes, nonionic surfactants, amphoteric surfactants, fluorinated surfactants, and mixtures thereof.

The polishing composition can be prepared by any suitable technique, many of which are known to those skilled in the art. The polishing composition can be prepared in a batch or continuous process. Generally, the polishing composition can be prepared by combining the components herein in any order. The term "component" as used herein includes individual ingredients (e.g., surface-modified colloidal silica particles, iron compound, stabilizing agent, etc.) as well as any combination of the ingredients.

For example, the iron compound and stabilizing agent can be added to the aqueous carrier (e.g., water) at the desired concentration(s). The pH can then be adjusted (as desired) and the surface-modified colloidal silica particles can be added to the mixture at the desired concentration to form the polishing composition. The polishing composition can be prepared prior to use, with one or more components added to the polishing composition just before use (e.g., within about 1 minute before use, or within about 1 hour before use, or within about 7 days before use). The polishing composition also can be prepared by mixing the components at the surface of the substrate during the polishing operation.

The polishing composition also can be provided as a concentrate which is intended to be diluted with an appropriate amount of the aqueous carrier, particularly water, prior to use. In such an embodiment, the polishing composition concentrate can comprise the surface-modified colloidal silica particles, iron compound, stabilizing agent, and aqueous carrier, in amounts such that, upon dilution of the concentrate with an appropriate amount of water, each component of the polishing composition will be present in the polishing composition in a concentration within the appropriate range recited above for each component. Furthermore, as will be understood by those of ordinary skill in the art, the concentrate can contain an appropriate fraction of the water present in the final polishing composition in order to ensure that other components are at least partially or fully dissolved in the concentrate.

While the polishing composition can be prepared well before, or even shortly before, use, the polishing composition also can be produced by mixing the components of the polishing composition at or near the point-of-use. As utilized herein, the term "point-of-use" refers to the point at which the polishing composition is applied to the substrate surface (e.g., the polishing pad or the substrate surface itself). When the polishing composition is to be produced using point-of-use mixing, the components of the polishing composition are separately stored in two or more storage devices.

As described herein, the invention provides a method of chemically-mechanically polishing a substrate comprising a tungsten layer on a surface of the substrate and silicon oxide layer on a surface of the substrate.

The inventive polishing method can be used to polish any suitable substrate comprising a tungsten layer and silicon oxide layer. Suitable substrates include, but are not limited to, flat panel displays, integrated circuits, memory or rigid disks, metals, semiconductors, inter-layer dielectric (ILD) devices, microelectromechanical systems (MEMS), 3D NAND devices, ferroelectrics, and magnetic heads. The polishing composition is particularly well-suited for planarizing or polishing a substrate that has undergone shallow trench isolation (STI) processing. Desirably, the substrate includes a dielectric-containing (e.g., silicon oxide-containing) surface, especially one having a region of pattern dielectric material that includes raised dielectric areas separated by trench areas of dielectric material. The substrate can further comprise at least one other layer, e.g., an insulating layer. The insulating layer can be a metal oxide, porous metal oxide, glass, organic polymer, fluorinated organic polymer, or any other suitable high or low-κ insulating layer. The insulating layer can comprise, consist essentially of, or consist of silicon oxide, silicon nitride, or combinations thereof. The silicon oxide layer can comprise, consist essentially of, or consist of any suitable silicon oxide, many of which are known in the art. For example, the silicon oxide layer can comprise tetraethoxysilane (TEOS), high density plasma (HDP) oxide, borophosphosilicate glass (BPSG), high aspect ratio process (HARP) oxide, spin on dielectric (SOD) oxide, chemical vapor deposition (CVD) oxide, plasma-enhanced tetraethyl ortho silicate (PETEOS), thermal oxide, or undoped silicate glass. The substrate can further comprise a metal layer. The metal can comprise, consist essentially of, or consist of any suitable metal, many of which are known in the art, such as, for example, copper, tantalum, tungsten, titanium, platinum, ruthenium, iridium, aluminum, nickel, or combinations thereof.

In another preferred embodiment, the substrate comprises tungsten plug and interconnect structures.

It is desirable that the polishing composition have suitable "selectivity" or "tunability" to obtain suitable polishing performance depending on the polishing application. Typically, it is desirable to have a high removal rate for tungsten relative to dielectric material (e.g., silicon oxide) to obtain a suitable processing throughput while still exhibiting suitable defectivity or erosion performance. The polishing compositions of the invention advantageously exhibit a removal rate selectivity such that the polishing compositions are suitable for blanket or bulk polishing applications. In addition, the inventive polishing compositions advantageously exhibit improved polishing performance (e.g., improved defectivity, reduced erosion, and reduced EOE) well suited for producing high quality devices from the processed substrate.

In some embodiments of the present invention, the ratio of the removal rate of the tungsten layer to the removal rate of the silicon oxide layer (i.e., W:TEOS ratio) is greater than about 20:1, for example, greater than about 25:1, greater than about 30:1, greater than about 35:1, greater than about 40:1, greater than about 45:1, greater than about 50:1, greater than about 55:1, greater than about 60:1, greater than about 65:1, greater than about 70:1, or greater than about 75:1.

The polishing performance of the inventive compositions can be evaluated using any suitable substrate or method. One type of substrate suitable for evaluating polishing performance is a substrate comprising a line and space (L&S) pattern, wherein a surface includes line fields and spaces. The line fields, or patterned fields, include line arrays of metal and oxide and can include isolated lines of metal in otherwise continuous fields of oxide. The line fields are distributed among fields (spaces) of continuous dielectric material. The line arrays include metal and oxide lines, such as lines of tungsten and silicon oxide, and may be of any density or size, for example alternating 1 µm-wide lines of metal and 1 µm-wide lines of oxide, i.e., a 50% 1 µm array, or alternating lines of different size or density, for example of 1 µm-wide lines of metal and 3 µm-wide lines of oxide, i.e., a 25% 1x3 µm array. The isolated metal lines typically are associated with the line arrays and are located in the oxide fields some distance from the arrays and typically are of the same dimension (width) as the metal lines in the array. For example, to one side of the 1×1 µm line array, there can be two 1 µm isolated lines of metal located in the otherwise continuous field of oxide and separated from one another and from the array by > 100 µm. The fields of continuous dielectric material, for comparison, may typically be larger in dimension, and have a surface of continuous dielectric material such as a silicon oxide, for example TEOS. An exemplary field (or "space") of continuous dielectric material can be a 100×100 µm area.

To evaluate post-polishing pattern performance of such L&S substrates, the absolute oxide loss (material removed) that occurs at the continuous dielectric field is determined, such as by an optical method using commercially available equipment (F5X tool supplied by KLA Tencor, Milpitas, CA). The continuous dielectric field is used as a reference for the relative pattern measurements in the arrays. For example, a line array comprised of alternating tungsten metal and TEOS oxide lines can be measured by profilometry or atomic force microscopy (AFM) with respect to the continuous field oxide. Erosion is characterized as a difference in the relative height of the oxide, such as the 1 µm TEOS lines, in the line array, as compared to the continuous field oxide. A positive erosion value is interpreted as relative recess of the oxide lines as compared to the continuous field oxide. Metal dishing typically refers to the relative height of the metal lines as compared to the oxide lines in the line array. For example, in a 50% 1×1 µm line array, a value of 200 Å dishing is interpreted as 200 Å recess of the tungsten lines relative to the oxide lines. Adding the erosion and the dishing provides the total step height, in this case from the recessed (dished tungsten) to the field oxide. Total oxide or metal loss in the array can be determined by combining the dishing and erosion values with the absolute oxide loss values determined for the continuous field.

Other erosion phenomena associated with patterns are areas of localized erosion, such as increased erosion associated with edges of the line arrays or increased erosion in areas near the isolated lines. For example, for 1 µm isolated line in a field of oxide, localized erosion can be observed as an increase in linewidth to >1 µm. The erosion can be described in terms of the increased linewidth or in terms of the linewidth increase to a particular depth with respect to the reference field or a combination of these two properties.

The chemical-mechanical polishing composition described herein and the method of the invention are particularly suited for use in conjunction with a chemical-mechanical polishing apparatus. Typically, the apparatus comprises a platen, which, when in use, is in motion and has a velocity that results from orbital, linear, or circular motion, a polishing pad in contact with the platen and moving with the platen when in motion, and a carrier that holds a substrate to be polished by contacting and moving the substrate relative to the surface of the polishing pad. The polishing of the substrate takes place by the substrate being placed in contact with the polishing pad and the polishing composition of the invention, and then the polishing pad moving relative to the substrate, so as to abrade at least a portion of the substrate to polish the substrate.

A substrate can be polished with the chemical-mechanical polishing composition using any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, co-formed products thereof, and mixtures thereof. Soft polyurethane polishing pads are particularly useful in conjunction with the inventive polishing method. Typical pads include but are not limited to SURFIN^{™} 000, SURFIN^{™} SSW1, SPM3100 Eminess Technologies), POLITEX^{™} (Dow Chemical Company), and POLYPAS^{™} 27 (Fujibo), NEXPLANAR^{™} E6088 and EPIC^{™} D100 pad commercially available from Cabot Microelectronics. A particularly preferred polishing pad is the rigid, microporous polyurethane pad (IC1010 ^{™}) commercially available from Dow Chemical.

Desirably, the chemical-mechanical polishing apparatus further comprises an in situ polishing endpoint detection system, many of which are known in the art. Techniques for inspecting and monitoring the polishing process by analyzing light or other radiation reflected from a surface of the substrate being polished are known in the art. Such methods are described, for example, in U.S. Patent 5,196,353, U.S. Patent 5,433,651, U.S. Patent 5,609,511, U.S. Patent 5,643,046, U.S. Patent 5,658,183, U.S. Patent 5,730,642, U.S. Patent 5,838,447, U.S. Patent 5,872,633, U.S. Patent 5,893,796, U.S. Patent 5,949,927, and U.S. Patent 5,964,643. Desirably, the inspection or monitoring of the progress of the polishing process with respect to a substrate being polished enables the determination of the polishing end-point, i.e., the determination of when to terminate the polishing process with respect to a particular substrate.

### EMBODIMENTS

(1) In embodiment (1) is presented a chemically-mechanically polishing a substrate comprising (i) providing a substrate, wherein the substrate comprises a tungsten layer on a surface of the substrate and a silicon oxide layer on a surface of the substrate; (ii) providing a polishing pad; (iii) providing a chemical-mechanical polishing composition comprising (a) surface-modified colloidal silica particles comprising a negatively-charged group on the surface of the particles, wherein the surface-modified colloidal silica particles have a negative charge, a particle size of about 90 nm to about 350 nm, and a zeta potential of about -20 mV to about -70 mV at a pH about 2, (b) an iron compound, (c) a stabilizing agent, and (d) an aqueous carrier; (iv) contacting the substrate with the polishing pad and the chemical mechanical polishing composition; and (v) moving the polishing pad and the chemical-mechanical polishing composition relative to the substrate to abrade at least a portion of the tungsten layer and at least a portion of the silicon oxide layer to polish the substrate.

In embodiment (2) is presented the method of embodiment (1), wherein the negatively-charged group on the surface of the surface-modified colloidal silica particles comprises a sulfonate group, a carboxylate group, a phosphonate group, or combinations thereof.

In embodiment (3) is presented the method of embodiment (1) or (2), wherein the surface-modified colloidal silica particles have a particle size of about 90 nm to about 180 nm.

In embodiment (4) is presented the method of embodiment (3), wherein the surface-modified colloidal silica particles have a particle size of about 120 nm to about 180 nm.

In embodiment (5) is presented the method of any one of embodiments (1)-(4), wherein the pH of the polishing composition is about 1.5 to about 3.

In embodiment (6) is presented the method of embodiment (5), wherein pH of the polishing composition is about 2 to about 3.

In embodiment (7) is presented the method of any one of embodiments (1)-(6), wherein the surface-modified colloidal silica particles are present in the polishing composition in a concentration of about 0.01 wt.% to about 6 wt.%.

In embodiment (8) is presented the method of embodiment (7), wherein the surface-modified colloidal silica particles are present in the polishing composition in a concentration of about 0.1 wt.% to about 4.5 wt.%.

In embodiment (9) is presented the method of any one of embodiments (1)-(8), wherein the iron compound comprises ferric nitrate or a hydrate thereof.

In embodiment (10) is presented the method of embodiment (9), wherein the iron compound is present in the polishing composition in a concentration of about 0.005 wt.% to about 0.1 wt.%.

In embodiment (11) is presented the method of any one of embodiments (1)-(10), wherein the stabilizing agent comprises phosphoric acid, o-phosphorylethanolamine, alendronic acid, acetic acid, phthalic acid, citric acid, adipic acid, oxalic acid, malonic acid, aspartic acid, succinic acid, glutaric acid, pimelic acid, suberic acid, azelaic acid, sebacic acid, maleic acid, glutaconic acid, muconic acid, ethylenediaminetetraacetic acid, propylenediaminetetraacetic acid, or combinations thereof.

In embodiment (12) is presented the method of embodiment (11), wherein the stabilizing agent comprises malonic acid.

In embodiment (13) is presented the method of any one of embodiments (1)-(12), wherein the stabilizing agent is present in the polishing composition in a concentration of about 0.01 wt. % to about 1.5 wt.%.

In embodiment (14) is presented the method of any one of embodiments (1)-(13), wherein the abrasion of at least a portion of the tungsten layer provides a removal rate for tungsten, wherein the abrasion of at least a portion of the silicon oxide layer provides a removal rate for silicon oxide, and wherein the ratio of the tungsten removal rate to the silicon oxide removal rate is greater than about 20:1.

### EXAMPLES

The following examples further illustrate the invention but, of course, should not be construed as in any way limiting its scope.

The following abbreviations are used herein: MPS refers to (3-mercaptopropyl)trimethoxysilane; W refers to tungsten; TEOS refers to tetraethoxysilane; and RR refers to removal rate.

### EXAMPLE 1

This example demonstrates the effectiveness in polishing a substrate comprising a tungsten layer on a surface of the substrate and silicon oxide layer on a surface of the substrate provided by the method of the invention using a chemical-mechanical polishing composition comprising surface-modified colloidal silica particles, an iron compound, a stabilizing agent, and an aqueous carrier, in accordance with an embodiment of the present invention.

Eight different polishing compositions (Polishing Compositions 1A-1H) were prepared using one of eight different colloidal silica particles (Particles P1-P8) as set forth in Tables 1 and 2. Colloidal silica Particle P1 was a comparative colloidal silica particle having an average particle size of 68 nm.

Surface-modified colloidal silica particles (P1-P8) were prepared as follows: a reactor (10 L) was charged with deionized water and a colloidal silica dispersion to provide 3.5 kg of a 10% (w/v) SiO₂ colloidal dispersion. To this was added 0.5 g of a KOH (45%) solution to adjust pH to approximately 8.5 followed by the addition of MPS with stirring in the amount indicated in Table 1. The reactor was heated to 45 °C and maintained at temperature for 48 hours, after which hydrogen peroxide (30%) was added in a 3:1 molar ratio of H₂O₂:MPS and the solution was stirred for 6 hours at 45 °C. The MPS and H₂O₂ reaction stoichiometry is set forth in Table 1.

**Table 1: Surface-Modified Colloidal Silica Particles**

| **Colloidal Silica Particle** | **Particle Size** | **MPS (wt.%)** | **H₂O₂ added (wt.%)** |
|---|---|---|---|
| P1 (comparative) | 68 nm | 0.129 | 0.224 |
| P2 | 100 nm | 0.079 | 0.137 |
| P3 | 120 nm | 0.028 | 0.049 |
| P4 | 120 nm | 0.042 | 0.073 |
| P5 | 120 nm | 0.057 | 0.098 |
| P6 | 160 nm | 0.03 | 0.052 |
| P7 | 174 nm | 0.028 | 0.048 |

Polishing Compositions 1A-1G were prepared using particles P1-P7 as follows: to a stirred solution of water (5.2 kg) was added malonic acid (5.3 g) as a stabilizing agent, iron nitrate nonahydrate (41.3 g of a 10% solution of iron nitrate nonahydrate) as an iron compound, anionic colloidal silica (250 g of an 11% solution of particle) and KATHON^{™} LX (0.3 g of a 10.6% solution) as a biocide. The pH of the solution was adjusted to 2.3 with nitric acid (70%) or potassium hydroxide (45%), as required. Prior to polishing, 2% hydrogen peroxide (30%) was added to each of the slurries as an oxidizing agent.

Substrates comprising a tungsten layer and a silicon oxide layer were separately polished with Polishing Compositions 1A-1G. The substrates were polished using a E6088 polishing pad (Cabot Microelectronics, Aurora, IL) under the following polishing conditions: tool = MIRRA^{™}, SFR = 150 mL/min, platen speed/head speed = 115/121 rpm, inner tube pressure = 159 hPa; retaining ring pressure = 186 hPa; membrane pressure = 138 hPa; and *ex. situ* conditioner = SAESOL^{™} D4 26.7 N.

The blanket polishing performance results, including removal rates (RR) are set forth in Table 2.

**Table 2: Blanket Film Performance: W-Bulk**

| **Polishing Composition** | **Colloidal Silica Particle** | **Particle Size** | **Zeta Potential** | **W (2k) RR (nm/min)** | **TEOS RR (nm/min)** | **W:TEOS ratio** |
|---|---|---|---|---|---|---|
| 1A (comparative) | P1 | 68 nm | -30 mV | 146.6 | 5.0 | 29 |
| 1B (inventive) | P2 | 100 nm | -30 mV | 267.1 | 6.7 | 40 |
| 1C (inventive) | P4 | 120 nm | -20 mV | 317.5 | 7.3 | 43 |
| ID (inventive) | P5 | 120 nm | -32 mV | 316.6 | 6.5 | 49 |
| IE (inventive) | P6 | 120 nm | -32 mV | 297.0 | 4.9 | 61 |
| IF (inventive) | P7 | 160 nm | -29 mV | 329.8 | 5.7 | 58 |
| 1G (inventive) | P8 | 174 nm | -36 mV | 329.2 | 5.9 | 56 |

As is apparent from the results set forth in Table 2, the inventive polishing compositions exhibit improved bulk polishing performance. For example, Polishing Compositions 1B-1G exhibited higher tungsten removal rates at a higher selectivity for tungsten relative to TEOS than the comparative Polishing Composition 1A. Inventive Polishing Composition IE exhibited a tungsten blanket removal rate that was nearly twice the tungsten removal rate of comparative Polishing Composition 1A, and inventive Polishing Composition IF exhibited about twice the selectivity for tungsten relative to TEOS as compared to comparative Polishing Composition 1A.

Patterned substrates comprising a tungsten layer and silicon oxide layer were polished using the following conditions: slurry flow rate = 150 mL/min, inner tube/retaining ring/membrane pressure = 3.3/2.7/2 (psi), platen speed/head speed = 115/121, conditioner = SAESOL^{™} D4 6 lbs *ex situ,* polish time = endpoint plus 20 seconds, median of 4 sites. The patterns were polished to laser endpoint and subsequently polished for a fixed time of 20 seconds, and the values represent means of 4 sites on the patterns.

The pattern polishing performance results are set forth in Table 3.

**Table 3: Pattern (MIT 2 k W854) Film Performance: W-Bulk**

| **Polishing Composition** | **Particle Size** | **Zeta Potential** | **0.18×0.18 µm erosion (+/- 1 nm )** | **0.18 µm isolated line local erosion (nm) (error)** | **1 µm isolated line local erosion (nm) (error)** |
|---|---|---|---|---|---|
| 1A (comparative) | 68 nm | -30 mV | 4 nm | 5 (2) | 11.1 (2.2) |
| 1B (inventive) | 100 nm | -30 mV | 7 nm | 2 (1) | 8.8 (1.6) |
| 1C (inventive) | 120 nm | -20 mV | 6 nm | 1 (0.6) | 5.5 (0.7) |
| ID (inventive) | 120 nm | -32 mV | 6 nm | 1 (0.6) | 6.1 (0.7) |
| IE (inventive) | 120 nm | -32 mV | 5 nm | 1 (0.6) | 4.8 (0.8) |
| IF (inventive) | 160 nm | -29 mV | 6 nm | 1 (0.6) | 5.8 (0.6) |
| 1G (inventive) | 174 nm | -36 mV | 7 nm | 1 (0.6) | 5.7 (0.8) |

As is apparent from the results in Table 3, the inventive polishing compositions exhibited improved polishing performance on patterned substrates. For example, the inventive Polishing Composition IE exhibited the same erosion value on the 0.18×0.18 µm line as that of comparative Polishing Composition 1A, within experimental error (i.e., 5 nm vs 4 nm), but exhibited only 20% the localized corrosion on the 0.18 µm isolated line (i.e., 1 nm vs. 5 nm), and has only half the localized corrosion on the 1 µm isolated line (i.e., 4.8 nm vs. 11.1 nm).

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description.

## Claims

1. A method of chemically-mechanically polishing a substrate comprising:
(i) providing a substrate, wherein the substrate comprises a tungsten layer on a surface of the substrate and a silicon oxide layer on a surface of the substrate;
(ii) providing a polishing pad;
(iii) providing a chemical-mechanical polishing composition comprising:
(a) surface-modified colloidal silica particles comprising a negatively-charged group on the surface of the particles, wherein the surface-modified colloidal silica particles have
a negative charge,
a particle size of 90 nm to 350 nm, wherein particle size refers to the diameter of the smallest sphere that encompasses the particle, and
a zeta potential of -20 mV to -70 mV at a pH of about 2,
(b) an iron compound,
(c) a stabilizing agent, and
(d) an aqueous carrier;
(iv) contacting the substrate with the polishing pad and the chemical mechanical polishing composition; and
(v) moving the polishing pad and the chemical-mechanical polishing composition relative to the substrate to abrade at least a portion of the tungsten layer and at least a portion of the silicon oxide layer to polish the substrate.

2. The method of claim 1, wherein the negatively-charged group on the surface of the surface-modified colloidal silica particles comprises a sulfonate group, a carboxylate group, a phosphonate group, or combinations thereof.

3. The method of claim 1, wherein the surface-modified colloidal silica particles have a particle size of 90 nm to 180 nm.

4. The method of claim 3, wherein the surface-modified colloidal silica particles have a particle size of 120 nm to 180 nm.

5. The method of claim 1, wherein the pH of the polishing composition is 1.5 to 3.

6. The method of claim 5, wherein the pH of the polishing composition is 2 to 3.

7. The method of claim 1, wherein the surface-modified colloidal silica particles are present in the polishing composition in a concentration of 0.01 wt.% to 6 wt.%.

8. The method of any claim 7, wherein the surface-modified colloidal silica particles are present in the polishing composition in a concentration of 0.1 wt.% to 4.5 wt.%.

9. The method of claim 1, wherein the iron compound comprises ferric nitrate or a hydrate thereof.

10. The method of claim 1, wherein the iron compound is present in the polishing composition in a concentration of 0.001 wt.% to 1.0 wt.%.

11. The method of claim 1, wherein the stabilizing agent comprises phosphoric acid, o-phosphorylethanolamine, alendronic acid, acetic acid, phthalic acid, citric acid, adipic acid, oxalic acid, malonic acid, aspartic acid, succinic acid, glutaric acid, pimelic acid, suberic acid, azelaic acid, sebacic acid, maleic acid, glutaconic acid, muconic acid, ethylenediaminetetraacetic acid, propylenediaminetetraacetic acid, or combinations thereof.

12. The method of claim 11, wherein the stabilizing agent comprises malonic acid.

13. The method of claim 1, wherein the stabilizing agent is present in the polishing composition in a concentration of 0.01 wt. % to 1.50 wt.%

14. The method of claim 1, wherein the abrasion of at least a portion of the tungsten layer provides a removal rate for tungsten, wherein the abrasion of at least a portion of the silicon oxide layer provides a removal rate for silicon oxide, and wherein the ratio of the tungsten removal rate to the silicon oxide removal rate is greater than 20:1

## Patentansprüche

1. Verfahren zum chemisch-mechanischen Polieren eines Substrats, das Folgendes umfasst:
(i) Bereitstellen eines Substrats, wobei das Substrat eine Wolframschicht auf einer Oberfläche des Substrats oder eine Siliciumoxidschicht auf einer Oberfläche des Substrats umfasst;
(ii) Bereitstellen eines Polierkissens;
(iii) Bereitstellen einer Zusammensetzung zum chemisch-mechanischen Polieren, umfassend:
(a) oberflächenmodifizierte kolloidale Siliciumdioxidteilchen mit einer negativgeladenen Gruppe an der Oberfläche der Teilchen, wobei die oberflächenmodifizierte kolloidalen Siliciumdioxidteilchen
eine negative Ladung,
eine Teilchengröße von 90 nm bis 350 nm, wobei sich Teilchengröße auf den Durchmesser der kleinsten Kugel, die das Teilchen umschließt, bezieht, und
ein Zeta-Potential von -20 mV bis -70 mV bei einem pH-Wert von etwa 2 aufweisen,
(b) eine Eisenverbindung,
(c) einen Stabilisator und
(d) einen wässrigen Träger;
(iv) Inkontaktbringen des Substrats mit dem Polierkissen und der Zusammensetzung zum chemisch-mechanischen Polieren und
(v) Bewegen des Polierkissens und der Zusammensetzung zum chemisch-mechanischen Polieren relativ zu dem Substrat zum Abschleifen mindestens eines Teils der Wolframschicht und mindestens eines Teils der Siliciumoxidschicht zum Polieren des Substrats.

2. Verfahren nach Anspruch 1, wobei die negativ geladene Gruppe an der Oberfläche der oberflächenmodifizierten kolloidalen Siliciumdioxidteilchen eine Sulfonatgruppe, eine Carboxylatgruppe, eine Phosphonatgruppe oder Kombinationen davon umfasst.

3. Verfahren nach Anspruch 1, wobei die oberflächenmodifizierten kolloidalen Siliciumdioxidteilchen eine Teilchengröße von 90 nm bis 180 nm aufweisen.

4. Verfahren nach Anspruch 3, wobei die oberflächenmodifizierten kolloidalen Siliciumdioxidteilchen eine Teilchengröße von 120 nm bis 180 nm aufweisen.

5. Verfahren nach Anspruch 1, wobei der pH-Wert der Polierzusammensetzung 1,5 bis 3 beträgt.

6. Verfahren nach Anspruch 5, wobei der pH-Wert der Polierzusammensetzung 2 bis 3 beträgt.

7. Verfahren nach Anspruch 1, wobei die oberflächenmodifizierten kolloidalen Siliciumdioxidteilchen in der Polierzusammensetzung in einer Konzentration von 0,01 Gew.-% bis 6 Gew.-% vorliegen.

8. Verfahren nach Anspruch 7, wobei die oberflächenmodifizierten kolloidalen Siliciumdioxidteilchen in der Polierzusammensetzung in einer Konzentration von 0,1 Gew.-% bis 4,5 Gew.-% vorliegen.

9. Verfahren nach Anspruch 1, wobei die Eisenverbindung Eisen(III)-nitrat oder ein Hydrat davon umfasst.

10. Verfahren nach Anspruch 1, wobei die Eisenverbindungen der Polierzusammensetzung in einer Konzentration von 0,001 Gew.-% bis 1,0 Gew.- % vorliegt.

11. Verfahren nach Anspruch 1, wobei der Stabilisator Phosphorsäure, *o*-Phosphorylethanolamin, Alendronsäure, Essigsäure, Phthalsäure, Citronensäure, Adipinsäure, Oxalsäure, Malonsäure, Asparaginsäure, Bernsteinsäure, Glutarsäure, Pimelinsäure, Suberinsäure, Azelainsäure, Sebacinsäure, Maleinsäure, Glutaconsäure, Muconsäure, Ethylendiamintetraessigsäure, Propylendiamintetraessigsäure oder Kombinationen davon umfasst.

12. Verfahren nach Anspruch 11, wobei es sich bei dem Stabilisator um Malonsäure handelt.

13. Verfahren nach Anspruch 1, wobei das Stabilisierungsmittel in der Polierzusammensetzung in einer Konzentration von 0,01 Gew.-% bis 1,50 Gew.-% vorliegt.

14. Verfahren nach Anspruch 1, wobei das Abschleifen mindestens eines Teils der Wolframschicht eine Abtragsrate für Wolfram bereitstellt, wobei das Abschleifen mindestens eines Teils der Siliciumoxidschicht eine Abtragsrate für Siliciumoxid bereitstellt und wobei das Verhältnis von Wolfram-Abtragsrate zu Siliciumoxid-Abtragsrate größer als 20:1 ist.

## Revendications

1. Procédé de polissage mécano-chimique d'un substrat comprenant :
(i) la mise à disposition d'un substrat, le substrat comprenant une couche de tungstène sur une surface du substrat et une couche d'oxyde de silicium sur une surface du substrat ;
(ii) la mise à disposition d'un tampon de polissage ;
(iii) la mise à disposition d'une composition de polissage mécano-chimique comprenant :
(a) des particules de silice colloïdale modifiées en surface comprenant un groupe chargé négativement sur la surface des particules, les particules de silice colloïdale modifiées en surface possédant
une charge négative,
une taille de particule de 90 nm à 350 nm, la taille de particule faisant référence au diamètre de la plus petite sphère qui englobe la particule, et
un potentiel zêta de -20 mV à -70 mV à un pH d'environ 2,
(b) un composé du fer,
(c) un agent stabilisant, et
(d) un support aqueux ;
(iv) la mise en contact du substrat avec le tampon de polissage et la composition de polissage mécano-chimique ; et
(v) le déplacement du tampon de polissage et de la composition de polissage mécano-chimique par rapport au substrat pour abraser au moins une partie de la couche de tungstène et au moins une partie de la couche d'oxyde de silicium pour polir le substrat.

2. Procédé selon la revendication 1, le groupe chargé négativement sur la surface des particules de silice colloïdale modifiées en surface comprenant un groupe sulfonate, un groupe carboxylate, un groupe phosphonate, ou des combinaisons correspondantes.

3. Procédé selon la revendication 1, les particules de silice colloïdale modifiées en surface possédant une taille de particule de 90 nm à 180 nm.

4. Procédé selon la revendication 3 les particules de silice colloïdale modifiées en surface possédant une taille de particule de 120 nm à 180 nm.

5. Procédé selon la revendication 1, le pH de la composition de polissage étant de 1,5 à 3.

6. Procédé selon la revendication 5, le pH de la composition de polissage étant de 2 à 3.

7. Procédé selon la revendication 1, les particules de silice colloïdale modifiées en surface étant présentes dans la composition de polissage en une concentration de 0,01 % en poids à 6 % en poids.

8. Procédé selon une quelconque revendication 7, les particules de silice colloïdale modifiées en surface étant présentes dans la composition de polissage en une concentration de 0,1 % en poids à 4,5 % en poids.

9. Procédé selon la revendication 1, le composé du fer comprenant du nitrate ferrique ou un hydrate correspondant.

10. Procédé selon la revendication 1, le composé du fer étant présent dans la composition de polissage en une concentration de 0,001 % en poids à 1,0 % en poids.

11. Procédé selon la revendication 1, l'agent stabilisant comprenant l'acide phosphorique, l'*o-*phosphoryléthanolamine, l'acide alendronique, l'acide acétique, l'acide phtalique, l'acide citrique, l'acide adipique, l'acide oxalique, l'acide malonique, l'acide aspartique, l'acide succinique, l'acide glutarique, l'acide pimélique, l'acide subérique, l'acide azélaïque, l'acide sébacique, l'acide maléique, l'acide glutaconique, l'acide muconique, l'acide éthylènediaminetétraacétique, l'acide propylènediaminetétraacétique ou des combinaisons correspondantes.

12. Procédé selon la revendication 11, l'agent stabilisant comprenant l'acide malonique.

13. Procédé selon la revendication 1, l'agent stabilisant étant présent dans la composition de polissage en une concentration de 0,01 % en poids à 1,50 % en poids.

14. Procédé selon la revendication 1, l'abrasion d'au moins une partie de la couche de tungstène fournissant une vitesse d'élimination du tungstène, l'abrasion d'au moins une partie de la couche d'oxyde de silicium fournissant une vitesse d'élimination de l'oxyde de silicium, et le rapport de la vitesse d'élimination du tungstène sur la vitesse d'élimination de l'oxyde de silicium étant supérieur à 20 : 1.
